Europäisches Patentamt

European Patent Office

Office européen des brevets

(11) Publication number: **0 108 065**
**B1**

# (12) EUROPEAN PATENT SPECIFICATION

(45) Date of publication of patent specification: **30.12.86**

(21) Application number: **83900009.8**

(22) Date of filing: **09.12.82**

(86) International application number:
**PCT/BE82/00024**

(87) International publication number:
**WO 83/02200 23.06.83 Gazette 83/15**

(51) Int. Cl.⁴: **H 01 L 31/02**

(54) **METHOD FOR MANUFACTURING SEMI-CONDUCTING DEVICES AND SEMI-CONDUCTING DEVICES THUS OBTAINED.**

(30) Priority: **10.12.81 LU 83831**

(43) Date of publication of application:
**16.05.84 Bulletin 84/20**

(45) Publication of the grant of the patent:
**30.12.86 Bulletin 86/52**

(84) Designated Contracting States:
**AT BE CH DE FR GB LI LU NL SE**

(56) References cited:
**EP-A-0 002 550**
**US-A-4 158 591**
**US-A-4 256 513**
**The Conference Record of the fourteenth IEEE Photovoltaic Specialists Conference - 1980, 7 - 10 January 1980, (San Diego, US), L. FRISSON et al: "Silicon solar cells with screen printed diffusion and metallization", pages 941-942**
**The Conference Record of the fourteenth IEEE photovoltaic specialists Conference - 1980, 7-10 January 1980, (San Diego, US) T. NUNOI et al: "High performance BSF silicon solar cell with fire trough contacts printed on AR coating", pages 805-810**

(73) Proprietor: **DE BELGISCHE STAAT -L'ETAT BELGE- vertegenwoordigd door de SECRETARIS-GENERAAL VAN DE DIENSTEN VOOR PROGRAMMATIE VAN HET WETENSCHAPSBELEID Wetenschapsstraat 8 B-1040 Brussel (BE)**

(72) Inventor: **FRISSON, Louis**
**Opheersestraat 80D**
**B-3870 Heers (BE)**
Inventor: **JANSSENS, Robert**
**Asterstraat 22**
**B-2440 Geel (BE)**
Inventor: **HONORE, Mia**
**Schueremanslaan 65/4A**
**B-3070 Kortenberg (BE)**
Inventor: **MERTENS, Robert Pierre**
**Koetsiersweg 50**
**B-3202 Linden (BE)**
Inventor: **Van OVERSTRAETEN, Roger**
**Leopold III laan 55**
**B-3030 Heverlee (BE)**

(74) Representative: **Schmitz, Yvon et al**
**Bureau Gevers S.A. 7, rue de Livourne Bte 1**
**B-1050 Bruxelles (BE)**

## Description

The invention relates to a method for manufacturing semi-conducting devices, particularly solar photovoltaic cells, comprising a sensitive front surface which is to be exposed to the sun radiation, and a back surface so arranged as to provide an ohmic contact.

Solar cells are semi-conducting devices with a very simple structure and they are generally comprised of a slice or lamina from p-type monocrystalline silicium, into which has been diffused to a short depth, a donor impurity, to obtain a n-type zone which is photo-sensitive and which is normally to be exposed to sun radiation, and to provide an n-p junction at a shallow depth. When the sun radiation does fall on the front or top surface of the solar cell, the light will be absorbed by the material and will form holes, that is voids in the valence electron layers. The electric field inside the n-p junction has such a polarity that the minority carriers are driven to the junction. This process causes an excess charge generating a potential difference of about 500 to 600 mV between n-type and p-type silicium. When the cell is connected to an outer circuit, a current will flow therein. To provide an electric contact on the front or top surface of the solar cell, a conducting material layer is laid thereon in the shape of a grid or comb. The connection on the back or bottom surface is provided by means of a metal film covering the whole surface area.

Men of the art use presently the silk-screen method for manufacturing solar cells. The introduction of the silk-screen method is motivated by the experience gained during the time period 1975—1978 as it became clear that the conventional manufacturing methods, particularly as it appeared that preparing by vaporizing of the metal pattern or model on the cell front surface through a mask, were not suitable to a manufacture on a large scale of solar cells. This is true both for the production capacity and the material efficiency, and regarding the capital costs.

It has been first tried to apply metal contacts or electrodes over the bottom and top surfaces by making use of silk-screen methods. The first experiments as well as the results given in the literature did show that those materials which causes the less problems were silver for the front part and aluminum for the back part of n-p solar cells. It already became clear during the first tests that the best throughputs were obtained when metal inks were applied over the front part after covering the cell with an anti-reflecting layer. The paste on the front or top part thus did diffuse through said anti-reflecting layer during the curing and did thus form a weak ohmic contact. An interesting method for forming a junction, lies in diffusing from doped layers which have in turn been applied by a silk screen process. In such a case, a doper layer is applied by silk-screening, from which layer the impurities are left to diffuse into the silicium slices, at a temperature from about 900° to 950°C. See, for that purpose, The Conference Record of the Fourteenth IEEE Photovoltaic Specialists' Conference 1980, 7—10 January 1980 (San Diego, US) L. Frisson et al: "Silicon solar cells with screen printed diffusion and metalization" pages 941—942, concerning a method for manufacturing a photovoltaic cell, which comprises the use of phosphorus doped paste for the diffusion process. Said phosphorus paste contains a powder of $P_2O_5$ as the main substance for the diffusion paste, a powder of $SiO_2$, an organic binder and to adjust the viscosity of the paste a solvent. However, tests have shown that when the paste is prepared on the basis of phosphorus pentoxide ($P_2O_5$) as active functional material, said material is changed under the action of moisture traces into phosphoric acid which attacks directly the screen.

The applying of the aluminum paste as such over the back surface did not cause any marked problem, but there was obtained a contact which could not or with difficulty only be soldered. A first possibility to obviate such drawback did lie in applying a copper layer by electroplating to obtain solderable contacts. Such process lies in applying a copper layer by electroplating over the aluminum layer and then dipping the cell into a solder bath. Copper plating is made by means of copper sulphate, sulfuric acid and some additives to improve said electroplating. Said method has a large advantage, notably due to the cells having a very low series resistance and thus a high charge coefficient. However in many cases, such an advantage does not balance the numerous disadvantages linked with such a technique. The production of solar cells with such electroplating and solder bath processes did prove very weak and this being partly due to the many broken cells resulting from the loading and unloading relative to the electroplating bath, and also due to the bad adherence of the cell metal deposit. Other drawbacks result from such technique being difficult to automatize and thus being expensive and relatively intricate, and moreover large amounts of acid have to continuously be discharged, which causes polluting problems. Another solution lies to obtain the contact with the silicium layer on the p side, in using aluminum pastes on the basis of silver powder, which metal has the advantage of providing an outstanding solderability. However due to the interacting between aluminum and silver during the thermal process, there is formed an alloy having bad solderability properties.

This invention lies in obviating said drawbacks from the known semi-conducting devices and in providing an industrially and economically valid method allowing to improve the production of semi-conducting devices, and particularly photovoltaic solar cells, as well as the throughput thereof relative to the conventional treatments, by means of metal plating of the back surface of said devices or cells, by means of a double silk-screen process. The method according to the invention while allowing to avoid forming on the back side of the semi-conducting device an alloy having low solderability features, is also characterized by the marked possibility of automatizing and the low capital costs required thereby, the same apparatus being usable both to form the junction and to electroplate, as well as due to the relatively low amount of chemical wastes it does generate.

The method of this invention is also characterized by the formation of a junction on the front side of the semi-conducting material by diffusion from a paste applied by silk-screening, which presents the advantage of not attacking the screen under the action of moisture traces, as in the case of the above mentioned process of Frisson et al.

For that purpose, according to a first embodiment, this invention provides a method comprising the following process steps:

1) applying a layer of phosphorus-doped paste by silk-screening on the front side of the substrate;

2) diffusing the phosphor into the substrate by controlled heat treatment to obtain a junction;

3) removing the remaining layer by chemical etching;

4) coating the doped front side with an anti-reflective material;

5) covering the anti-reflective coating by silk-screening with a layer of silver-based paste;

6) subjecting the silver-based paste to a controlled heat treatment;

7) applying by silk-screening on the back side of the substrate a first layer of an aluminium paste;

8) applying by silk-screening on the first layer a second layer of paste on the basis of silver and palladium;

9) subjecting the first and second layers to a controlled heat treatment;
the method being characterized in that

a) the phosphorus-doped paste consists of a phosphorus compound selected from polyphosphoric acid and the esters from polyphosphoric· acid, solvent and colloidal silica;

b) the covering rate of the second layer on the back side lies between 10% and 40%;

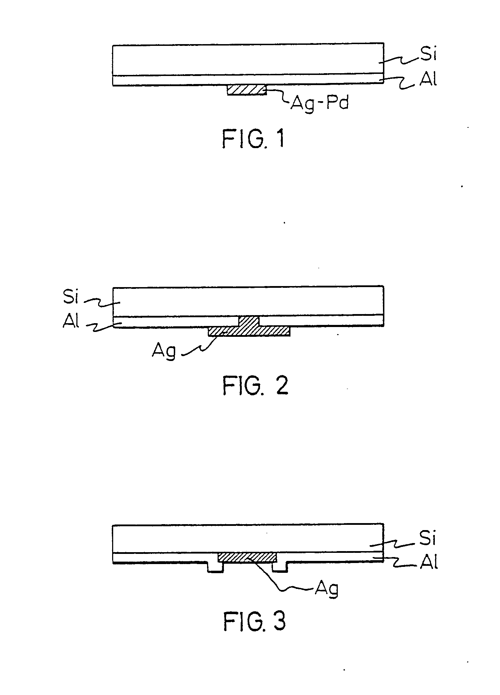

c) the palladium content of the second layer lies between 25% and 45% by weight (Figure 1).

According to a second embodiment, this invention provides a method comprising the following process steps:

1) applying a layer of phosphorus-doped paste by silk-screening on the front side of the substrate;

2) diffusing the phosphor into the substrate by controlled heat treatment to obtain a junction;

3) removing the remaining layer by chemical etching;

4) coating the doped front side with an anti-reflective material;

5) covering the anti-reflective coating by silk-screening with a layer of silver-based paste;

6) subjecting the silver-based paste to a controlled heat treatment;

7) applying by silk-screening on the back side of the substrate a first layer of an aluminium paste;

8) applying by silk-screening on the first layer a second layer of paste;

9) subjecting the first and second layers to a controlled heat treatment;
the method being characterized in that

a) the phosphorus-doped paste consists of a phosphorus compound selected from polyphosphoric acid and the esters from polyphosphoric acid, solvent and colloidal silica;

b) the second layer on the back side is a silver paste which is applied into openings provided in the first aluminium paste layer and over an adjacent portion of the aluminium paste;

c) the covering rate of the second layer on the back side lies between 10% and 40% (Figure 2).

According to a third embodiment, this invention provides a method comprising the following process steps:

1) applying a layer of phosphorus-doped paste by silk-screening on the front side of the substrate;

2) diffusing the phosphor into the substrate by controlled heat treament to obtain a junction;

3) removing the remaining layer by chemical etching;

4) coating the doped front side with an anti-reflective material;

5) covering the anti-reflective coating by silk-screening with a layer of silver-based paste;

6) subjecting the silver-based paste to a controlled heat treatment;

7) applying by silk-screening on the back side of the substrate a first and a second layer of a paste;

8) subjecting the first and second layers to a controlled heat treatment;
the method being characterized in that

a) the phosphorus-doped paste consists of a phosphorus compound selected from polyphosphoric acid and the esters from polyphosphoric acid, a solvent and colloidal silica;

b) the first paste layer on the back side of the substrate is a silver paste the covering rate of which lies between 10% and 40%;

c) the second paste layer on the back side of the substrate is an aluminium paste which covers the back side portion which is not covered with the silver paste and a portion of the adjacent silver paste layer (Figure 3).

In a preferred embodiment, after the application thereof, said first and second layers are each dried respectively at a temperature about 150°C for about 10 minutes, and then subjected to curing for about one hour up to a maximum curing temperature about 650° to 800°C, or else said first and second layers are then subjected simultaneously after drying of the second layer, to curing for about one hour up to a maximum curing temperature about 650° to 800°C, said maximum curing temperature being retained in both cases, for about 8 to 10 minutes, while keeping a temperature gradient of no more than 50°C/min, the maximum curing temperature being preferably of about 660° to about 720°C.

In another embodiment of the invention, the solvent is selected from the group comprising the butyl carbitol acetate, butylcellulose acetate, ethylene-glycol ethers and diethylene-glycol ethers and the phosphorus proportion in the paste lies preferably between about 10 and 15% by weight.

In still another preferred embodiment, said silver-based paste covering the anti-reflecting material layer contains about 3 to 6% by weight tin.

In a particularly advantageous embodiment of the invention, after the application thereof, said silver paste layer with tin is dried at a temperature in the range of 100°C for about 10 minutes and said layer is then subjected to curing for about one hour up to a maximum curing temperature about 780° to 820°C, the maximum curing temperature being retained for about 5 minutes, while keeping a temperature gradient of no more than 50°C/min.

The invention further comprises the semi-conducting devices, particularly the photovoltaic solar cells, which are obtained with said method.

Other details and features of the invention will stand out from the following description, given by way of non limitative example and with reference to the accompanying drawings, in which:

Figure 1 is a diagrammatic section view of the back part from a solar cell according to the invention.

Figure 2 is a diagrammatic section view through another embodiment of the back part from a solar cell according to the invention.

Figure 3 is a diagrammatic section view through still another embodiment of the back part from a solar cell according to the invention.

In the various figures, the same reference numerals pertain to similar elements.

The following description pertains particularly to the manufacture of solar cells on the basis of silicium. It is clear that most of the steps in the method according to the invention may also be applied to the manufacture of other semi-conducting components, such as for example solar cells from other materials than silicium, power-generating components and generally, when it is a matter of combining the techniques pertaining to semi-conductors and to thick films.

The silicium slices, generally with a diameter about 7,62 cm and a thickness about 300 microns are attacked by polishing in a first step, to obtain a perfectly plane surface devoid of any impurity and bump due to sawing on the surface. Chemical etching is generally more advantageous from the economic point of view, than mechanical polishing. Moreover such an operation takes less time. During chemical etching, the silicium slices are dipped into an etching bath on the basis of nitric acid, hydrogen fluoride and glacial acetic acid. A particularly suitable etching bath will have for this purpose, the following composition: 64% nitric acid (at 65%), 16% hydrogen fluoride (at 48%), and 20% glacial acetic acid. The reaction time is dependent on the liquid temperature and the amount of liquid having reacted. After chemical etching, the silicium slices or laminae are dried in acetone vapours. The acetone temperature lies generally between 50° and 55°C. This operation occurs by holding the silicium slices above an acetone bath. However care should be taken due to the inflammability of acetone.

After such first attack, slices are obtained with a thickness about 250 to 300 microns. The slices are marked with a diamond to determine the front side thereof.

A junction may be obtained on the front side of said silicium slices, in two different ways. The first way lies in making the junction by diffusion in the gaseous phase; such technique is presently perfectly developed and well known from the men of the art. The second technique, as already stated hereinbefore, lies in forming the junction by diffusing from a paste applied by silk-screening; this technique has been substantially improved within the scope of this invention and has given in some conditions, better results and efficiencies than the technique of diffusion in the gaseous phase. Both said techniques will be described hereinafter.

a) Forming a junction by diffusing from the gaseous phase.

A first step in the forming of a junction lies in cleaning with nitric acid at a temperature of about 80°C. The object of this operation is to insure that the surface is completely clean, in such a way that diffusing may occur as homogeneously as possible over the complete surface area, and to prevent some impurities from entering the silicium during the diffusion process, which process is performed at a very high temperature. To dispose of the oxide which develops during the cleaning, the silicium slices are for example dipped in sequence in a solution with 5% hydrogen fluoride. There is then performed a water cleaning and a drying in acetone vapours, as for the drying step during polishing of said slices.

The silicium slices are then brought into a diffusion oven and arranged on a boat-shaped piece of quartz. The slices are set upright on the quartz boat by introducing same through small slits which have been provided therein. A normal diffusion batch comprises about 30 cells. Use can be made for this purpose of a "Lindberg"-type diffusion oven. The oven is fed with oxygen as well as with a small nitrogen flow, which is fed as bubbles through a doping material source, for example $POCl_3$ (phosphorus oxychloride) before entering the tunnel oven. It must be understood that the use of other doping materials than phosphorus, such as for instance antimonium or arsenic, might be considered. Said phosphorus oxychloride is a liquid which is present inside a small tank secured to the oven side wall. Said small nitrogen flow thus takes the phosphorus atoms along inside the oven which has a temperature about 920°C. The doping phosphorus will settle down on the silicium and diffuse therein from the surface in a perfectly re-productible way. After diffusing for about 20 minutes, a junction depth about 0.4 micron deep is obtained, which means a layer resistance about 20 to 30 ohms per square. Diffusing from the gaseous phase occurs everywhere over the silicium slice, in such a way that the interfering junction being formed on the slice back side has to be removed by chemical etching. The useful junction on the front part is protected against the etching liquid by means for instance, of a photolacquer (Shipley 1350 H). The etching or chemical-attack liquid is preferably comprised of water, nitric acid and hydrogen fluoride; a particularly suitable etching bath contains for example 50% water, 40% nitric acid (at 65%), and 10% hydrogen fluoride (at 48%). After dipping for one or two minutes in the bath, it is insured that a layer a few microns thick has been removed by etching. The photolacquer is then removed in fuming nitric acid, after which cleaning of the silicium slices is performed with nitric acid (65%) at 80°C and then by means of an aqueous solution from hydrogen fluoride at 5%.

b) Forming a junction by diffusing from a paste applied by silk-screening.

Another method according to the invention for forming a junction, lies in diffusing from doped layers which have in turn been applied by a silk-screen process. In such a case, a doped layer is applied by silk-screening, from which layer the impurities are left to diffuse into the silicium slices, at a temperature from about 900° to 950°C.

Preparing the diffusion paste requires caution as regards etching of the screen during the silk-screen process by means of the paste. Tests have shown that when the paste is prepared on the basis of phosphorus pentoxide ($P_2O_5$) as active functional material, like in the case of the above mentioned method of Frisson et al, said material is changed under the action of moisture traces, into phosphoric acid which attacks directly the screen. It is thus imperative to apply the functional material as polyphosphoric acid. It has been noted according to the invention, that polyphosphoric acid converted into a silk-screening paste does not attack the screen, as opposed to phosphorus pentoxide.

Preparing the paste does actually occur in two steps:

(1) Preparing the functional material;

2) Converting said material into a paste which may be applied by silk-screening (2).

(1) Functional material.

Use is made for this purpose, either directly of polyphosphoric acid, or of esters from polyphosphoric acid.

Polyphosphoric acid is obtained by reacting phosphoric acid ($H_3PO_4$ at 300%) with phosphorus pentoxide. The molecular ratio lies about 20 ($H_3PO_4$ at 100%/$P_2O_5$). The mixture is slightly heated and after about 10 minutes, there is obtained a homogeneous product. Cooling is performed inside a dryer. The phosphorus amount by weight in this product is normally about 29 to 30%. The ethyl ester from polyphosphoric acid is also a product of great interest.

Said ethyl ester is the product from reacting tri-ethyl phosphate and phosphorus pentoxide. The molecular ratio between both said reagents (tri-ethyl phosphate/$P_2O_5$) lies between 4 and 14; a ratio of 8 is normally used. It has been noted according to the invention, that with smaller molecular ratios, the reaction occurs faster, but then during preparing of the paste proper, the possibilities of mixing with the solvent are worse. On the other hand, with higher ratios, the reaction occurs more slowly, but the mixing possibilities are getting better. The normal reaction temperature is 210°C and the reaction is performed with backflow. After a few hours, the reaction is stopped, that is when the tri-ethyl phosphate has reacted. This is noticed due to a very strong increase in the temperature of the residue and a high vapour generating. Care should be taken not to let the reaction last for too long; this might generate small brownish flakes, which would require filtering the diluted residue, but would lower the paste quality. The phosphorus amount by weight which is finally present in the residue, which will be dependent on the functional material, lies between 22 and 30%, and this according to the conditions under which the reaction is performed. Instead of ethyl ester of polyphosphoric acid, use may be made of other esters of polyphosphoric acid, such as the butyl ester of polyphosphoric acid. In this case, use will be made of tri-butyl phosphate instead of tri-ethyl phosphate.

(2) Converting into a silk-screening paste.

The functional material is diluted with cooling, until there is obtained a solution containing about 10 to 15% and preferably 12% by weight, of phosphorus. Diluting of the functional material normally occurs by means of butylcarbitol acetate or butylcellulose acetate; other solvents which might be used within the scope of this invention, are ethylen glycol and diethylen glycol ethers, such as monobutyl, monoethyl, monomethyl, dimethyl, and diethyl ethers of diethylene glycol. Said reaction product as diluted is very liquid and cannot be used for silk-screening. It is thickened up to the required viscosity with a particular colloidal form of silica, such as aerosil. The aerosil is a very pure silicium dioxide formed of spherical particles with very small diameters (mean value from 10 to 20 microns) and which as such, has a very large specific surface area (50 to 350 m²/gr). As the aerosil absorbs moisture, said material has first to be dried before being used. The silica proportion is dependent on the kind of silica being used and comprises, for example, 7.7% by weight for "aerosol 130". Another material which can be used for this purpose is "Cab-O-Sil" from Cabot Corporation, or other colloidal forms from silicium oxide.

The residue obtained on the silicium slice, after silk-screening with phosphorus-diffusion paste and after drying at a temperature about 150°C, to expel the solvent, is a dispersion of silicium dioxide in the material containing the phosphorus. The layer is strongly viscous, but not solid. The layer of phosphorus-doped paste, after drying at a temperature in the range of 150°C, is then subjected to curing to cause diffusing of the phosphorus for a period of time between 45 minutes and 1.5 hours, up to a maximum curing temperature about 900° to 950°C, the maximum curing temperature being retained for about 15 to 20 minutes, while keeping a temperature gradient no higher than about 50°C/minute. During the feeding of the phosphorus-doping material during the diffusion step at a temperature of 900°—950°C, the paste clearly flows down the edges of the cell and forms a short-circuit to the metal contact on the back side thereof. The edges of the cells obtained in this way have thus to be treated to remove the leak remains which might interfere with the cell efficiency. However the resulting junction on the cell edges may easily be removed by arranging hundreds of cells on one another and by "dry" etching the resulting cylinder in a plasma equipment.

The application proper of the phosphorus-based starting material is made inside a continuous oven, by controlling the temperature in the above-defined way. The remaining layer, after the diffusion step, is removed by chemical etching with an aqueous solution of hydrogen fluoride, for example at 48%, such chemical etching being followed by cleaning with water and drying in acetone vapours.

Due to the phosphorus doping material entering in this case, but on the front side, there thus occurs no interfering junction on the slice back side, which does not have thereby to be treated with an etchant. The application as well as the · drying and curing operations for the phosphorus-doped paste layer are preferably made according to the invention, in a nitrogen atmosphere. As already stated, the conventional phosphorus diffusion process occurs inside an open tunnel-oven inside which the silicium slices are arranged vertically in a quartz "boat", the phosphorus source being the phosphorus oxichloride. Said conventional process has, as the use thereof for manufacturing solar cells is contemplated, two substantial drawbacks relative to the diffusion process according to the invention performed from a paste which is applied by silk-screening:

a) It is a discontinuous process. A determined number (usually a few tens, possibly a few hundreds slices) of slices have to be arranged on a quartz "boat". The boat has to be slipped inside the oven and removed therefrom, and it must be unloaded.

b) Due to the silicium slices being arranged vertically, the diffusion occurs not only on the front side, but also on the back side of said slices. This causes forming of an interfering junction on the back side. Such interfering diffusion may only be removed cell by cell, generally by using chemical etching aqueous baths.

According to the invention, said drawbacks are obviated when use is made of the silk-screen technique as described hereinabove to apply a doped paste, and when using a heat treatment inside a continuous oven.

On the one hand, as regards point (a), it is clear that an automatic silk-screen machine which works in combination with a continuous oven (for example belt conveyor), is a continuous process. On the other hand, as regards point (b), it will be noted that due to the use of a silk-screening step, the doping material is applied but on the cell front side. During the heat treatment, while the cells are arranged horizontally on the movable belt inside the continuous oven, the junction will be formed but on the front side, together, as mentioned hereinabove, with an interfering junction which is only formed on the cell edges, but which does not extend on the back side thereof, as this occurs with the conventional diffusion method. As already stated, the junction which is formed on the cell edges may easily be removed with a plasma equipment.

The doped front side of the silicium slices is then coated, in a way known per se, with an anti-reflecting material layer. Reckoning a mean value of 4 for the reflection index of the silicium, a 36% reflection is obtained on the silicium surface with an incidence at right angle. Such reflection may be lowered by laying down a layer between the air layer and the silicium layer, which layer would have a refraction index $n_{ARL} = \sqrt{n_{air} \cdot n_{Si}} = 2$. In such a case, the reflection is zero for a wave length $\lambda = 4 \, n_{ARL} \cdot d$, formula in which d is the thickness of the anti-reflecting layer.

When such a minimum reflecting is desired for $\lambda = 7000$ Å, this occurs with a layer thickness

$$d = \frac{\lambda}{4 \, n_{ARL}} = 875 \text{ Å}.$$

Several materials having a refraction index lying about 2 may be used for solar cells; particularly suitable materials are as follows: $SiO_2$, $TiO_x$ with x=1, 2, etc, $Ta_2O_5$, and mixtures of these various substances. Within the scope of this invention, use is preferably made of $TiO_x$ which is applied by the so-called "spin-on" process. A few drops of $TiO_x$ in a solvent laid down on the silicium slice, which is rotated at about 3000 rev/min, give the required thickness to the anti-reflecting layer (ARL). Said solvent is vaporized at a temperature about 250°C and there remains an uniform layer with a blue colouring.'

The front side of the silicium slices is metallized by making use again of a silk-screening process. It is well known that titanium improves the contact between silicium and silver. Use is made in this case for metallizing the front side, of a silver paste in the form of a thick film, which may be obtained commercially under the Trade Name ESL 5964, to which is added some proportion of Ti. It has been noted in this aspect, in a way known per se, that particularly good results were obtained by adding 4 to 7% titanium powder to the silver paste.

Once applied over the front side of the silicium slice, the titanium-enriched silver paste layer is dried to a temperature about 100°C for about 10 minutes and it is then subjected to curing for about one hour up to a maximum curing temperature about 850° to 860°C. Such temperatures do indeed allow to obtain generally a good ohmic contact. On the other hand, it has been noticed that the short-circuit current decreased with the increase in temperature, due to degrading of the minor charge carriers. This is a well-known phenomenon in the semi-conductor technology.

While a higher sintering temperature gives an improved contact and consequently a better charge factor, there results also therefrom a degrading of the short-circuit current, in such a way that an optimum curing temperature appears to lie about 860°C. The curing profile is such that the cells remain for about 5 minutes at the peak temperature, while keeping a temperature gradient no higher than 50°C/min.

Even if the peak temperature during said heat treatment should be high enough for the paste to be suitably sintered, which also improves the conductivity of the layer and enhances forming of a low enough contact resistance with the silicium, it has been noticed that the impurities which are present in the silver paste diffuse all the more rapidly in the silicium as the peak temperature rises during the sintering process. When adding an element to the silver paste which lowers the melting point, it is possible to perform the sintering process at lower temperatures. It is clear that use should be made for that purpose, of elements which either do not diffuse into silicium, or do not influence adversely the junction properites of the solar cell. It has been noticed according to the invention, that the tin and antimonium elements did fulfil both conditions. Excellent results have been obtained by adding to the silver paste, about 3 to 6% and preferably 5% by weight tin. Such tin addition allows to lower by about 50° to 70°C the maximum sintering temperature of the metallizing on the front side (for example 860°C without tin down to 800°C when using tin), which allows obtaining higher short-circuit currents and better efficiencies. For instance, as for the silver paste with titanium, the silver paste with tin is dried after application thereof, at a temperature about 100°C for about 10 minutes, but it is then subjected to curing for about one hour up to a maximum curing temperature about 780° to 820°C, the maximum curing temperature being also retained for about 5 minutes, while keeping a temperature gradient no higher than 50°C/min.

Very similar results have been obtained by adding to the silver paste, about 3 to 7% by weight antimonium, and preferably 5% by weight antimonium, such antimonium addition, as well as the tin addition, has also allowed to lower substantially the maximum sintering temperature (by about 50° to 70°C) for the metallizing on the front side, and thus to obtain the same advantages as with the tin addition. In the case of blending antimonium, the layer of silver paste with antimonium is dried after the application thereof, at a temperature about 100°C for about 10 minutes and it is then subjected to curing for about one hour up to a maximum curing temperature about 760° to 840°C, the maximum curing temperature being retained for about 5 minutes, while keeping a temperature gradient no higher than 50°C/min.

By lowering the curing temperature by about 50° to 70°C, there is thus obtained a current gain about $\pm 1$ mA/cm$^2$, which corresponds to a relative current gain about 4%. Another very substantial advantage, as it has precisely been stated, resulting from this curing temperature lowering lies in the smaller diffusing of the impurities from the metallizing paste into the junction at a shallow depth, which results besides a better efficiency of the method as mentioned in a lower leak current and a better reproducing possibility.

For metallizing the back side of the cells, use is made of an aluminum paste which is applied by silk-screening, as for example that aluminum paste commercially available under the Trade Name of Engelhardt T-2497. Even while said aluminum pastes applied by silk-screening allow to obtain a good ohmic contact, they have for drawback a rather bad soldering capacity. This is the reason why it is required to apply over the aluminum, a layer which may be soldered. One solution to obviate this drawback lies as already stated, in applying a copper layer by electroplating. As already stated, such technology is relatively intricate and large amounts of acid have to be continuously discharged, which causes polluting problems. On the other hand, should it happen that one or more cells draw for whatever reason, more current, a larger copper amount will settle in this location. This results in the current flow further increasing, which causes the deposit of even more copper and this to the expense of the other cells. Due to this non-proportional distribution of the current, there is thus obtained a cumulating action as some cells obtain more current, which causes a rougher grain during the deposit as well as stresses in the layer being deposited, which may become so strong that a bad adherence may result therefrom. Another solution lies in using aluminum pastes on the basis of silver powder but as stated previously, due to the interaction between aluminum and silver during the heat process, there occurs an alloy having bad solderability features.

For all these reasons, another method has been searched for to obtain a solderable contact on the back side. According to the invention, a solution has been found with a method making use of an additional silk-screening step. Over the aluminum layer applied by silk-screening, there is laid also by silk-screening, a second layer the covering rate of which on the aluminum layer lies between 10 and 40%, preferably between 15 and 25%, said second layer being comprised either of a paste on the basis of silver and palladium the proportion of palladium of which is at least 25% by weight, and preferably lying between 30 and 45% by weight, the aluminum layer being applied in such a case over the complete back side of the silicium slice (see Figure 1), or of a silver paste, the aluminum layer being applied in such a case over a substantial portion of the back side of the silicium slice (see figure 2).

In this latter case, as it may be seen, the aluminum layer is actually applied by means of a selective pattern or template, and the silver layer application is made over the silicium through openings provided in the aluminum paste layer, as well as over that surface portion from the aluminum paste bordering said openings. If there is insured as shown in Figure 2, a large enough covering of the aluminum paste layer with the silver layer, a good ohmic contact is obtained over that portion where the aluminum is covered with silver, while the center portion where the silver lies far away enough from the aluminum, may be soldered. Said silk-screen methods both allow opposing the forming of an aluminum-silver alloy having bad solderability properties. Inks on the basis of silver and palladium have however the drawback of being relatively expensive.

Another solution which lies in reversing the sequence of application of said aluminum and silver layers, also allows to obtain very good results both from the point of view of the ohmic contact as of the solderability. For this purpose according to the invention, as may be seen in Figure 3, there is applied by silk-screening over the back side of the semi-conducting substrate slice, by way of first layer, the silver paste layer the covering rate of which over the back side lies between 10 and 40%, and preferably between 15 and 25%. Thereafter, there is also laid down by silk-screening over that portion of the back side which is not covered with silver paste and over a portion from the first silver layer, preferably over that surface portion of the silver layer adjacent to the aluminum layer or bordering same, the aluminum paste layer by way of second layer.

The metallizing of the cell back side occurs in the following way. The cell back side is first of all coated by silk-screening with aluminum paste (Figures 1 and 2).

The cells are then dried at a temperature about 150°C for about 10 minutes and there is then applied thereon, still by silk-screening, the silver-palladium or silver paste, and this is again dried at a temperature about 150°C, said second layer comprising that zone where the soldering of the electric contact will occur. The cells are then subjected to curing inside a continuous oven for about one hour up to a maximum curing temperature about 650° to 800°C, the maximum curing temperature being retained for about 8 to 10 minutes, while keeping a temperature gradient no higher than 50°C/min. Particularly good results have been obtained by making use of a maximum curing temperature about 660° to 720°C. The above-described operation may also be performed in two steps: applying the aluminum paste, drying at a temperature about 150°C for about 10 minutes, passing through the oven for about one hour up to a maximum curing temperature about 650° to 800°C; applying the silver-palladium or silver paste, drying at a temperature about 150°C for about 10 minutes, again passing through the oven for about one hour at a maximum curing temperature about 650° to 800°C. The maximum curing temperature during both said steps, is also retained for about 8 to 10 minutes, while keeping a temperature gradient no higher than 50°C/min.

In that case where the application sequence of the aluminum and silver layers is reversed (Figure 3), that is when the silver layer is applied first and then the aluminum layer, the metallizing operation on the back side occurs exactly under the same treatment conditions as the ones defined above.

It is imperative according to this invention, that the maximum curing temperature be adjusted within narrow limits, because with too high a temperature, the aluminum diffuses too rapidly in the silver-palladium or silver layer, and causes a non-solderable contact to be formed. The silver paste and mostly the silver-palladium paste being very costly, said paste will only be applied in those locations which are possibly to be soldered, in such a way that the covering rate of said layer over the aluminum layer (Figures 1 and 2) or over the silicium substrate (Figure 3) will in no case be larger than 40%.

The following examples illustrate the invention without however limiting same. The comparison examples show conventional methods and are given with the purpose of better showing off the advantages secured with this invention.

The production tests described hereinafter have been made with a pilot production line with a capacity of about 5 KW. The production line in all of the following examples, comprises the following apparatus and has the following features:

a) Diffusion oven: loading and unloading are made by hand. The oven capacity for making reproducible tests is 50 slices from 5.08 cm and 30 slices from 7.62 cm.

b) Dust-free volume for all of the chemical operations, such as polishing by chemical attack, applying coatings or layers, chemical etching of the interfering junction, chemical etching of the remaining layer after silk-screen diffusion.

c) Device for silk-screen application and through-oven; the drying occurs over a heated plate. In the equipment, the semi-automatic silk-screen device, the drying plate and the through-oven are not coupled automatically together, in such a way that loading and unloading have to be made completely by hand.

d) The copper electroplating bath is a 50-liter bath fitted with two racks allowing to treat simultaneously 16 cells from 1.27 cm. Soldering is made by hand in a static solder bath. Rinsing is also made by hand in an ultrasonic bath.

## Comparison Example 1

In this reproduction test, a start was made with 360 slices from 7.62 cm to produce 7201/2 slices from 7.62 cm. Said cells have been produced with a conventional method of gaseous diffusion, metallizing of the front side by means of AgTi and of the back side by means of Al, said latter operation being followed with a conventional copper electroplating and dipping in a solder bath; 6% from the cells had mechanical flaws (mostly during electroplating) or had an efficiency lower than 8%. 12% from the cells had an efficiency lying between 8 and 10%. Cell production according to this method, with a throughput higher than 10%, was 82%. The final throughput was 10.9%.

## Comparison Example 2

A start is made in this example, with 330 complete slices from 7.62 cm to obtain 330 substantially square solar cells. The process being followed is identical to the process in Comparison Example 1. But 3% from the cells had an efficiency between 8 and 10%. The final production is but 67%, which is due to the breakage during the handling for the electroplating process and mainly the breakage due to scribing the slices for passing from the round shape to the quasi-square shape.

## Example 1

A start is made in this production test with 330 quasi-square cells. Use is made in this test, of a conventional diffusion and of a metallizing paste on the basis of silver and tin on the front side. The lower curing temperature being used gives a higher current. The metallizing on the back side has been obtained by means of a double silk-screen process, first of all on the basis of aluminum, and then on the basis of silver and palladium. The production was 80% and the mean efficiency was about 11.4%.

## Example 2

A start is made in this test, from 450 quasi-square cells. The diffusing is performed by means of the silk-screen process and the metallizing is made by means of a Ag-Sn paste on the front side and of a paste from Al and Ag-Pd on the back side. Sawing to obtain quasi-square cells was performed after the diffusion, in such a way that part of the paste flow which is usually present on the cell edges was removed. The cell production having an efficiency higher than 8%, was 92% and the cell production with an efficiency higher than 9%, was 86%, which is high relative to the values obtained with the conventional methods.

## Example 3

A start was also made in this test, from 450 quasi-square cells. Diffusing is performed by means of the silk-screen process and metallizing is made by means of an Ag-Sb paste on the front side, and of paste from Al and Ag-Pd on the back side. Sawing to obtain quasi-square cells was also performed after the diffusion, in such a way that part of the paste flow which is usually present on the cell edges was removed. The cell production with an efficiency higher than 8%, was 94% and the cell production with an efficiency higher than 9% was 87%, which is also very high relative to the values obtained with the conventional methods.

The conclusions which may be drawn from the production test as described hereinabove, may be summarized as follows:

— By changing from the electroplating process to the double silk-screen process according to the invention, the throughput may reach 85%.
— By adding Sn or Sb to that silver paste which is laid over the front side, it was possible to substantially lower the curing temperature, which has secured a marked improvement in the throughput. The mean efficiency is 11.3%.
— In a complete silk-screen process, it is presently possible to insure a production of 85% with a minimum efficiency of 9% for quasi-square cells. Those cells the edges of which have been entirely treated or removed, for example by making use of a plasma equipment, have a substantially higher efficiency. Minimum efficiencies about 11% are obtained in this case.

**Claims**

1. Method for manufacturing a semi-conducting device, particularly a photovoltaic cell, composed of a semi-conducting substrate, such as silicium, in the shape of a slice, with a photo-sensitive front side and a back side provided with an ohmic contact, which comprises the following process steps:
1) applying a layer of phosphorus-doped paste by silk-screening on the front side of the substrate;
2) diffusing the phosphor into the substrate by controlled heat treatment to obtain a junction;
3) removing the remaining layer by chemical etching;
4) coating the doped front side with an anti-reflecting material;
5) covering the anti-reflective coating by silk-screening with a layer of silver-based paste;
6) subjecting the silver-based paste to a controlled heat treatment;
7) applying by silk-screening on the back side of the substrate a first layer of an aluminium paste;
8) applying by silk screening on the first layer a second layer of paste on the basis of silver and palladium;
9) subjecting the first and second layers to a controlled heat treatment;
the method being characterized in that
a) the phosphorus-doped paste consists of a phosphorus compound selected from polyphosphoric acid and the esters from polyphosphoric acid, solvent and colloidal silica;
b) the covering rate of the second layer on the back side lies between 10% and 40%;

c) the palladium content of the second layer lies between 25% and 45% by weight (Figure 1).

2. Method for manufacturing a semi-conducting device, particularly a photovoltaic cell, composed of a semi-conducting substrate, such as silicium, in the shape of a slice, with a photo-sensitive front side and a back side provided with an ohmic contact, which comprises the following process steps:

1) applying a layer of phosphorus-doped paste by silk-screening on the front side of the substrate;

2) diffusing the phosphor into the substrate by controlled heat treatment to obtain a junction;

3) removing the remaining layer by chemical etching;

4) coating the doped front side with an anti-reflective material;

5) covering the anti-reflective coating by silk-screening with a layer of silver-based paste;

6) subjecting the silver-based paste to a controlled heat treatment;

7) applying by silk-screening on the back side of the substrate a first layer of an aluminium paste;

8) applying by silk screening on the first layer a second layer of paste;

9) subjecting the first and second layers to a controlled heat treatment;
the method being characterized in that

a) the phosphorus-doped paste consists of a phosphorus compound selected from polyphosphoric acid and the esters from polyphosphoric acid, solvent and colloidal silica;

b) the second layer on the back side is a silver paste which is applied into openings provided in the first aluminium paste layer and over an adjacent portion of the aluminium paste;

c) the covering rate of the second layer on the back side lies between 10% and 40% (Figure 2).

3. Method for manufacturing a semi-conducting device, particularly a photovoltaic cell, composed of a semi-conducting substrate, such as silicium, in the shape of a slice, with a photo-sensitive front side and a back side provided with an ohmic contact, which comprises the following process steps:

1) applying a layer of phosphorus-doped paste by silk-screening on the front side of the substrate;

2) diffusing the phosphor into the substrate by controlled heat treatment to obtain a junction;

3) removing the remaining layer by chemical etching;

4) coating the doped front side with an anti-reflective material;

5) covering the anti-reflective coating by silk-screening with a layer of silver-based paste;

6) subjecting the silver-based paste to a controlled heat treatment;

7) applying by silk-screening on the back side of the substrate a first and a second layer of a paste;

8) subjecting the first and second layers to a controlled heat treatment;
the method being characterized in that

a) the phosphorus-doped paste consists of a phosphorus compound selected from polyphosphoric acid and the esters from polyphosphoric acid, a solvent and colloidal silica;

b) the first paste layer on the back side of the substrate is a silver paste the covering rate of which lies between 10% and 40%;

c) the second paste layer on the back side of the substrate is an aluminium paste which covers the back side portion which is not covered with the silver paste and a portion of the adjacent silver paste layer (Figure 3).

4. Method as defined in any one of claims 1 to 3, characterized in that, after the application thereof, said first and second layers are each dried respectively at a temperature about 150°C for about 10 minutes, and then subjected to curing for about one hour up to a maximum curing temperature about 650° to 800°C, said maximum curing temperature being retained for about 8 to 10 minutes, while keeping a temperature gradient no higher than 50°C/min.

5. Method as defined in any one of claims 1 to 3, characterized in that, after the application thereof, said first and second layers are each dried at a temperature about 150°C for about 10 minutes, and they are then subjected simultaneously after drying of the second layer, to curing for about one hour up to a maximum curing temperature about 650° to 800°C, the maximum curing temperature being retained for about 8 to 10 minutes, while keeping a temperature gradient no higher than 50°C/min.

6. Method as defined in either one of claims 4 and 5, characterized in that the maximum curing temperature is about 660° to 720°C.

7. Method as defined in any one of claims 1 to 6, characterized in that the phosphorus-doped paste contains from 10 to 15% by weight phosphorus.

8. Method as defined in any one of claims 1 to 7, characterized in that the solvent is selected from the group comprising the butyl carbitol acetate, butylcellulose acetate, ethylene-glycol ethers and diethylene-glycol ethers.

9. Method as defined in any one of claims 1 to 8, characterized in that the phosphorus-doped paste layer is dried at a temperature about 150°C, and it is then subjected to curing to cause diffusing of the phosphorus for a time period between 45 minutes and 1,5 hours up to a maximum curing temperature about 900° to 950°C, the maximum curing temperature being retained for about 15 to 20 minutes, while keeping a temperature gradient no higher than 50°C/min.

10. Method as defined in any one of claims 1 to 9, characterized in that the layer of silver paste covering the anti-reflecting material layer, contains about 4 to 7% by weight titanium and, after the application thereof, is dried at a temperature about 100°C for about 10 minutes, and it is then subjected to curing for about one hour up to a maximum curing temperature about 850° to 860°C, the maximum curing temperature being retained for about 5 minutes, while keeping a temperature gradient no higher than 50°C/min.

11. Method as defined in any one of claims 1 to 9, characterized in that the silver-based paste layer covering the anti-reflecting material layer contains about 3 to 6% by weight tin.

12. Method as defined in claim 11, characterized in that, after the application thereof, said silver paste layer with tin is dried at a temperature in the range of 100°C for about 10 minutes and said layer is then subjected to curing for about one hour up to a maximum curing temperature about 780° to 820°C, the maximum curing temperature being retained for about 5 minutes, while keeping a temperature gradient no higher than 50°C/min.

13. Method as defined in any one of claims 1 to 9, characterized in that the silver-based paste layer covering the anti-reflecting material contains about 3 to 7% by weight antimonium and, after the application thereof, is dried at a temperature about 100°C for about 10 minutes and it is then subjected to curing for about one hour up to a maximum curing temperature about 760° to 840°C, the maximum curing temperature being retained for about 5 minutes, while keeping a temperature gradient no higher than 50°C/min.

**Patentansprüche**

1. Verfahren zum Herstellen einer Halbleitervorrichtung, insbesondere einer photovoltaischen Zelle, bestehend aus einem halbleitenden Substrat, wie z.B. Silizium, in Form einer Scheibe mit einer photoempfindlichen Vorderseite und einer Rückseite, die mit einem ohmischen Kontakt versehen ist, enthaltend die folgenden Verfahrensschritte:

1) Aufbringen einer Schicht einer Phosphordotierten Paste durch Siebdruck auf der Vorderseite des Substrats;

2) Diffundieren des Phosphorus in das Substrat durch gesteuerte Wärmebehandlung, um eine Bindung zu erzielen;

3) Entfernen der übrigen Schicht durch chemisches Ätzen;

4) Beschichten der dotierten Vorderseite mit einem Antireflexionsmaterial;

5) Bedecken der antireflektierenden Schicht durch Siebdruck mit einer Schicht aus einer Paste auf Silberbasis;

6) Unterwerfen der Paste auf Silberbasis einer gesteuerten Wärmebehandlung;

7) Aufbringen einer ersten Schicht aus einer Aluminiumpaste durch Siebdruck auf der Rückseite des Substrats;

8) Aufbringen einer zweiten Schicht einer Paste auf der Basis von Silber und Palladium durch Siebdruck auf der ersten Schicht;

9) Unterwerfen der ersten und zweiten Schichten einer gesteuerten Wärmebehandlung; wobei das Verfahren dadurch gekennzeichnet ist, daß

a) die Phosphor-dotierte Paste aus einer Phosphorverbindung besteht, die ausgewählt ist aus Phosphorsäure und den Estern von Phosphorsäure, Lösungsmittel und kolloidalem Siliziumoxyd;

b) die Bedeckungsrate der zweiten Schicht auf der Rückseite zwischen 10 und 40% liegt;

c) der Palladiumgehalt der zweiten Schicht zwischen 25 und 45 Gew.-% liegt (Fig. 1).

2. Verfahren zum Herstellen einer Halbleitervorrichtung, insbesondere einer photovoltaischen Zelle, bestehend aus einem halbleitenden Substrat, wie beispielsweise Silizium, in Gestalt einer Scheibe, mit einer photoempfindlichen Vorderseite und einer Rückseite, die mit einem ohmischen Kontakt versehen ist, enthaltend die folgenden Verfahrensschritte:

1) Aufbringen einer Schicht aus Phosphordotierter Paste durch Siebdruck auf der Vorderseite des Substrats;

2) Diffundieren des Phosphors in das Substrat durch gesteuerte Wärmebehandlung, um eine Bindung zu erzielen;

3) Entfernen der übrigen Schicht durch chemisches Ätzen;

4) Beschichten der dotierten Vorderseite mit einem Antireflexionsmaterial;

5) Bedecken der Antireflexionsbeschichtung durch Siebdruck mit einer Schicht einer Paste auf Silberbasis;

6) Unterwerfen der Paste auf Silberbasis einer gesteuerten Wärmebehandlung;

7) Aufbringen einer ersten Schicht aus einer Aluminiumpaste durch Siebdruck auf der Rückseite des Substrats;

8) Aufbringen einer zweiten Pastenschicht durch Siebdruck auf der ersten Schicht;

9) Unterwerfen der ersten und zweiten Schichten einer gesteuerten Wärmebehandlung; wobei das Verfahren dadurch gekennzeichnet ist, daß

a) die Phosphor-dotierte Paste aus einer Phosphorverbindung besteht, die ausgewählt ist aus Phosphorsäure und den Estern von Phosphorsäure, Lösungsmittel und kolloidalem Siliziumoxyd;

b) die zweite Schicht auf der Rückseite einer Silberpaste ist, die in Öffnungen eingebracht ist, die in der ersten Aluminiumpastentschicht ausgebildet sind, sowie über einen benachbarten Bereich der Aluminiumpaste aufgebracht ist;

c) die Bedeckungsrate der zweiten Schicht auf der Rückseite zwischen 10 und 40% liegt (Fig. 2).

3. Verfahren zum Herstellen einer Halbleitervorrichtung, insbesondere einer photovoltaischen Zelle, bestehend aus einem halbleitenden Substrat, wie z.B. Silizium, in Gestalt einer Scheibe, mit einer photoempfindlichen Vorderseite und einer Rückseite, die mit einem ohmischen Kontakt versehen ist, enthaltend die folgenden Schritte:

1) Aufbringen einer Schicht aus Phosphordotierter Paste durch Siebdruck auf der Vorderseite des Substrats;

2) Diffundieren des Phosphors in das Substrat durch gesteuerte Wärmebehandlung, um eine Bindung zu erzielen;

3) Entfernen der übrigen Schicht durch chemisches Ätzen;

4) Beschichten der dotierten Vorderseite mit einem Antireflexionsmaterial;

5) Bedecken der Antireflexionsbeschichtung durch Siebdruck mit einer Schicht einer Paste auf Silberbasis;

6) Unterwerfen der Paste auf Silberbasis einer gesteuerten Wärmebehandlung;

7) Aufbringen einer ersten und einer zweiten Pastenschicht auf der Rückseite des Substrats mittels Siebdruck;

8) Unterwerfen der ersten und zweiten Schichten einer gesteuerten Wärmebehandlung; wobei das Verfahren dadurch gekennzeichnet ist, daß

a) die Phosphor-dotierte Paste aus einer Phosphorverbindung besteht, die ausgewählt ist aus Phosphorsäure und den Estern von Phosphorsäure, einem Lösungsmittel und kolloidalem Siliziumoxyd;

b) die erste Pastenschicht auf der Rückseite des Substrats eine Silberpaste ist, deren Bedeckungsrate zwischen 10% und 40% liegt;

c) die zweite Pastenschicht auf der Rückseite des Substrats eine Aluminiumpaste ist, die den Rückseitenabschnitt, der nicht von der Silberpaste bedeckt ist, und einen Abschnitt benachbart der Silberpastenschicht bedeckt (Fig. 3).

4. Verfahren nach einem der Ansprüche 1 bis 3, dadurch gekennzeichnet, daß nach der Aufbringung derselben die ersten und zweiten Schichten jeweils bei einer Temperatur von etwa 150°C für jeweils etwa 10 Minuten getrocknet und dann einer Härtung für etwa eine Stunde bei einer maximalen Aushärtungstemperatur bis zu etwa 650° bis 800°C unterworfen werden, wobei die maximale Härtungstemperatur für etwa 8 bis 10 Minuten aufrechterhalten wird, während ein Temperaturgradient von nicht höher als 50°C/min eingehalten wird.

5. Verfahren nach einem der Ansprüche 1 bis 3, dadurch gekennzeichnet, daß nach dem Aufbringen derselben die ersten und zweiten Schichten jeweils bei einer Temperatur von etwa 150°C für etwa 10 Minuten getrocknet werden und dann gleichzeitig nach dem Trocknen der zweiten Schicht einer Härtung für etwa eine Stunde bis zu einer maximalen Härtungstemperatur von etwa 650°C bis 800°C unterworfen werden, wobei die maximale Härtungstemperatur für etwa 8 bis 10 Minuten eingehalten wird, während ein Temperaturgradient von nicht höher als 50°C/min eingehalten wird.

6. Verfahren nach einem der Ansprüche 4 und 5, dadurch gekennzeichnet, daß die maximale Härtungstemperatur etwa 660° bis 720°C beträgt.

7. Verfahren nach einem der Ansprüche 1 bis 6, dadurch gekennzeichnet, daß die Phosphor-dotierte Paste 10 bis 15 Gew.-% Phosphor enthält.

8. Verfahren nach einem der Ansprüche 1 bis 7, dadurch gekennzeichnet, daß das Lösungsmittel ausgewählt ist aus der Gruppe enthaltend Butylcarbitolacetat, Butylzelluloseacetat, Äthylenglykoläther und Diäthylenglykoläther.

9. Verfahren nach einem der Ansprüche 1 bis 8, dadurch gekennzeichnet, daß die Phosphor-dotierte Pastenschicht bei einer Temperatur von etwa 150°C getrocknet und dann der Härtung für eine Zeitdauer zwischen 45 Minuten und 1,5 Stunden bis zu einer maximalen Härtungstemperatur von etwa 900° bis 950°C unterworfen wird, um Diffusion des Phosphors hervorzurufen, wobei die maximale Härtuntstemperatur für etwa 15 bis 20 Minuten aufrechterhalten wird, während ein Temperaturgradient von nicht höher als 50°C/min eingehalten wird.

10. Verfahren nach einem der Ansprüche 1 bis 9, dadurch gekennzeichnet, daß die Schicht aus Silberpaste, die die Antireflexionsmaterialschicht bedeckt, etwa 4 bis 7 Gew.-% Titan enthält und nach der Aufbringung derselben bei einer Temperatur von etwa 100°C für etwa 10 Minuten getrocknet wird und dann der Härtung für etwa eine Stunde bis zu einer maximalen Härtungstemperatur von etwa 850° bis 860°C unterworfen wird, wobei die maximale Härtungstemperatur für etwa 5 Minuten aufrechterhalten wird, während ein Temperaturgradient von nicht höher als 50°C/min eingehalten wird.

11. Verfahren nach einem der Ansprüche 1 bis 9, dadurch gekennzeichnet, daß die Pastenschicht auf Silberbasis, die die Antireflexionsmaterialschicht bedeckt, etwa 3 bis 6 Gew.-% Zinn enthält.

12. Verfahren nach Anspruch 11, dadurch gekennzeichnet, daß nach der Aufbringung derselben die Silberpastenschicht mit Zinn bei einer Temperatur im Bereich von 100°C für etwa 10 Minuten getrocknet wird und daß diese Schicht dann der Härtung für etwa eine Stunde bis zu einer maximalen Härtungstemperatur von etwa 780° bis 820°C unterworfen wird, wobei die maximale Härtungstemperatur für etwa 5 Minuten aufrechterhalten wird, während ein Temperaturgradient von nicht höher als 50°C/min eingehalten wird.

13. Verfahren nach einem der Ansprüche 1 bis 9, dadurch gekennzeichnet, daß die Pastenschicht auf Silberbasis, die das Antireflexionsmaterial bedeckt, etwa 3 bis 7 Gew.-% Antimon enthält und nach dem Aufbringen derselben bei einer Temperatur von etwa 100°C für etwa 10 Minuten getrocknet wird und dann der Härtung für etwa eine Stunde bis zu einer maximalen Härtungstemperatur von etwa 760° bis 840°C unterworfen wird, wobei die maximale Härtungstemperatur für etwa 5 Minuten aufrechterhalten wird, während ein Temperaturgradient von nicht höher als 50°C/min eingehalten wird.

**Revendications**

1. Procédé de fabrication d'un dispositif semiconducteur, en particulier d'une cellule photovoltaïque, comprenant un substrat semiconducteur, tel que du silicium, sous forme de tranche, avec une face avant photosensible et une face arrière pourvue d'un contact ohmique, qui comprend les étapes de traitement suivantes:

(1) l'application d'une couche de pâte dopée au phosphore par sérigraphie sur la face avant du substrat;

(2) la diffusion du phosphore dans le substrat par un traitement thermique contrôlé pour obtenir une jonction;

(3) la séparation de la couche restante par attaque chimique;

(4) l'enduction de la face avant dopée d'une matière antiréfléchissante;

(5) le recouvrement de l'enduit antiréfléchissant par sérigraphie d'une couche de pâte à base d'argent;

(6) la soumission de la pâte à base d'argent à un traitement thermique contrôlé;

(7) l'application par sérigraphie sur la face arrière du substrat d'une première couche formée d'une pâte d'aluminium;

(8) l'application par sérigraphie sur la première couche d'une seconde couche de pâte à base d'argent et de palladium;

(9) la soumission des première et seconde couches à un traitement thermique contrôlé; ce procédé étant caractérisé en ce que:

a) la pâte dopée au phosphore comprend un composé de phosphore choisi parmi l'acide polyphosphorique et les esters d'acide polyphosphorique, un solvant et de la silice colloïdale;

b) le taux de couverture de la seconde couche sur la face arrière est compris entre 10% et 40%;

c) la teneur en palladium de la seconde couche est comprise entre 25% et 45% en poids (Figure 1).

2. Procédé de fabrication d'un dispositif semiconducteur, en particulier d'une cellule photo-voltaïque, comprenant un substrat semi-conducteur, tel que du silicium, sous forme de tranche, avec une face avant photosensible et une face arrière pourvue d'un contact ohmique, qui comprend les étapes de traitement suivantes:

1) l'application d'une couche de pâte dopée au phosphore par sérigraphie sur la face avant du substrat;

2) la diffusion du phosphore dans le substrat par un traitement thermique contrôlé pour obtenir une jonction;

3) la séparation de la couche restante par attaque chimique;

4) l'enduction de la face avant dopée d'une matière antiréfléchissante;

5) le recouvrement de l'enduit antiréfléchissant par sérigraphie d'une couche de pâte à base d'argent;

6) la soumission de la pâte à base d'argent à un traitement thermique contrôlé;

7) l'application par sérigraphie sur la face arrière du substrat d'une première couche formée d'une pâte d'aluminium;

8) l'application par sérigraphie sur la première couche d'une seconde couche de pâte;

9) la soumission des première et seconde couches à un traitement thermique contrôlé; ce procédé étant caractérisé en ce que:

a) la pâte dopée au phosphore comprend un composé de phosphore choisi parmi l'acide polyphosphorique et les esters d'acide polyphosphorique, un solvant et de la silice colloïdale;

b) la seconde couche sur la face arrière est une pâte d'argent qui est appliquée dans des ouvertures prévues dans la première couche de pâte d'aluminium et sur une partie adjacente de la pâte d'aluminium;

c) le taux de couverture de la seconde couche sur la face arrière est compris entre 10% et 40% (Figure 2).

3. Procédé de fabrication d'un dispositif semiconducteur, en particulier d'une cellule photo-voltaïque, comprenant un substrat semi-conducteur, tel que du silicium, sous forme de tranche, avec une face avant photosensible et une face arrière pourvue d'un contact ohmique, qui comprend les étapes de traitement suivantes:

1) l'application d'une couche de pâte dopée au phosphore par sérigraphie sur la face avant du substrat;

2) la diffusion du phosphore dans le substrat par un traitement thermique contrôlé pour obtenir une jonction;

3) la séparation de la couche restante par attaque chimique;

4) l'enduction de la face avant dopée d'une matière antiréfléchissante;

5) le recouvrement de l'enduit antiréfléchissant. par sérigraphie d'une couche de pâte à base d'argent;

6) la soumission de la pâte à base d'argent à un traitement thermique contrôlé;

7) l'application par sérigraphie sur la face arrière du substrat d'une première et d'une seconde couche de pâte;

8) la soumission des première et seconde couches à un traitement thermique contrôlé; ce procédé étant caractérisé en ce que:

a) la pâte dopée au phosphore comprend un composé de phosphore choisi parmi l'acide polyphosphorique et les esters d'acide polyphosphorique, un solvant et de la silice colloïdale;

b) la première couche de pâte sur la face arrière du substrat est une pâte d'argent dont le taux de couverture est compris entre 10% et 40%;

c) la seconde couche de pâte sur la face arrière du substrat est une pâte d'aluminium qui recouvre la partie de la face arrière qui n'est pas recouverte de pâte d'argent et une partie de la couche de pâte d'argent adjacente (Figure 3).

4. Procédé suivant l'une quelconque des revendications 1 à 3, caractérisé en ce qu'après leur application, les première et seconde couches précitées sont chacune respectivement séchées à une température de l'ordre de 150°C pendant une durée de l'ordre de 10 minutes et ensuite soumises à une cuisson pendant une période de l'ordre d'une heure jusqu'à une température de cuisson maximale de l'ordre de 650°C à 800°C, la température de cuisson maximale étant maintenue pendant environ 8 à 10 minutes, en observant un gradient de température ne dépassant pas 50°C/minute.

5. Procédé suivant l'une quelconque des revendications 1 à 3, caractérisé en ce qu'après leur application, les première et seconde couches précitées sont chacune séchées à une température de l'ordre de 150°C pendant une période de l'ordre de 10 minutes et en ce qu'elles sont ensuite soumises simultanément après le séchage de la seconde couche à une cuisson pendant une période de l'ordre d'une heure jusqu'à une température de cuisson maximale de l'ordre de 650°C à 800°C, la température de cuisson maximale étant maintenue pendant environ 8 à 10 minutes, en observant un gradient de température ne dépassant pas 50°C/minute.

6. Procédé suivant l'une ou l'autre des revendications, 4 et 5, caractérisé en ce que la température de cuisson maximale est de l'ordre de 660 à 720°C.

7. Procédé suivant l'une quelconque des revendications 1 à 6, caractérisé en ce que la pâte dopée au phosphore contient de 10 à 15% en poids de phosphore.

8. Procédé suivant l'une quelconque des revendications 1 à 7, caractérisé en ce que le solvant est choisi dans le groupe comprenant l'acétate de butylcarbitol, l'acétate de butylcellulose, les éthers d'éthylène-glycol et les éthers de diéthylène-glycol.

9. Procédé suivant l'une quelconque des revendications 1 à 8, caractérisé en ce que la couche de pâte dopée au phosphore est séchée à une température de l'ordre de 150°C et est ensuite soumise à une cuisson pour provoquer la diffusion du phosphore pendant une période comprise entre 45 minutes et 1,5 heure jusqu'à une température de cuisson maximale de l'ordre de 900 à 950°C, la température de cuisson maximale étant maintenue pendant environ 15 à 20 minutes, en observant un gradient de température ne dépassant pas 50°C/minute.

10. Procédé suivant l'une quelconque des revendications 1 à 9, caractérisé en ce que la couche de pâte à base d'argent recouvrant la couche de matière antiréfléchissante contient environ 4 à 7% en poids de titane et en ce qu'après son application elle est séchée à une température de l'ordre de 100°C pendant une période de l'ordre de 10 minutes et est ensuite soumise à une cuisson pendant une période de l'ordre de 1 heure jusqu'à une température de cuisson maximale d'environ 850 à 860°C, la température de cuisson maximale étant maintenue pendant environ 5 minutes, en observant un gradient de température ne dépassant pas 50°C/minute.

11. Procédé suivant l'une quelconque des revendications 1 à 9, caractérisé en ce que la couche de pâte à base d'argent recouvrant la couche de matière antiréfléchissante contient environ de 3 à 6% en poids d'étain.

12. Procédé suivant la revendication 11, caractérisé en ce qu'après son application, la couche de pâte d'argent à l'étain est séchée à une température de l'ordre de 100°C pendant une durée de l'ordre de 10 minutes et est ensuite soumise à une cuisson pendant une période de l'ordre de une heure jusqu'à une température de cuisson maximale d'environ 780 à 820°C, la température de cuisson maximale étant maintenue pendant environ 5 minutes, en observant un gradient de température ne dépassant pas 50°C/minute.

13. Procédé suivant l'une quelconque des revendications 1 à 9, caractérisé en ce que la couche de pâte à base d'argent recouvrant la matière antiréfléchissant contient environ 3 à 7% en poids d'antimoine et en ce qu'après son application, elle est séchée à une température de l'ordre de 100°C pendant une durée de l'ordre de 10 minutes et est ensuite soumise à une cuisson pendant une période de l'ordre de une heure jusqu'à une température de cuisson maximale d'environ 760 à 840°C, la température de cuisson maximale étant maintenue pendant environ 5 minutes, en observant un gradient de température ne dépassant pas 50°C/minute.

FIG. 1

FIG. 2

FIG. 3